**Europäisches Patentamt**

**European Patent Office**

**Office européen des brevets**

(19)

(11) Veröffentlichungsnummer : **0 564 438 A1**

(12) # EUROPÄISCHE PATENTANMELDUNG

(21) Anmeldenummer : **93890058.6**

(22) Anmeldetag : **29.03.93**

(51) Int. Cl.⁵ : **H01J 37/12,** H01J 37/30

(30) Priorität : **30.03.92 AT 638/92**

(43) Veröffentlichungstag der Anmeldung :
**06.10.93 Patentblatt 93/40**

(84) Benannte Vertragsstaaten :
**AT BE CH DE DK ES FR GB GR IE IT LI LU MC
NL PT SE**

(71) Anmelder : **IMS Ionen Mikrofabrikations
Systeme Gesellschaft m.b.H.
Schreygasse 3
A-1020 Wien (AT)**

(72) Erfinder : **Chalupka, Alfred, Dr.
Laverangasse 24
A-1130 Wien (AT)**
Erfinder : **Stengl, Gerhard, Dr.
Umberg 41
A-9241 Wernberg, Kärnten (AT)**
Erfinder : **Vonach, Herbert, Prof. Dr.
Martinstrasse 83
A-3400 Klosterneuburg (AT)**

(74) Vertreter : **Casati, Wilhelm, Dipl.-Ing. et al
Krause Dipl.-Ing. Ernst Casati Dipl.-Ing.
Wilhelm Amerlingstrasse 8
A-1061 Wien (AT)**

(54) **Teilchen-, insbes. ionenoptisches Abbildungssystem.**

(57)    Die Erfindung betrifft ein teilchen-, insbes.
ionenoptisches Abbildungssystem, bevorzugt
für Lithographiezwecke, mit einer Teilchen-,
insbes. Ionenquelle Q zur Abbildung einer auf
einer Maske M befindlichen Struktur in Gestalt
einer oder mehrerer Öffnungen über mindestens zwei zwischen der Maske M und einem
Wafer W befindliche Sammellinsen L1, L2 auf
den Wafer W, wobei mindestens eine der Sammellinsen L1, L2 eine Dreielektroden-Linse ist,
welche aus zwei Rohrelektroden R1, R2 besteht, zwischen denen sich eine dritte Elektrode
befindet, welche als Platte mit einer Vielzahl
von Öffnungen, bevorzugt als Gitter G, ausgebildet ist, und wobei die Platte, insbes. das
Gitter G, senkrecht zur optischen Achse D angeordnet ist, so daß durch die Platte bzw. das
Gitter G die Linse L1 bzw. L2 in Zwei Bereiche
geteilt ist, und wobei bevorzugt an die drei
Elektroden R1, R2, G unterschiedliche Spannungen U1, U2, U3 angelegt werden.

FIG.6

Unter den verschiedenen Schritten, die zur Herstellung von Halbleiterbauelementen ausgeführt werden müssen, ist der Lithographieschritt besonders wichtig. Vereinfacht ausgedrückt, beginnt jeder Lithographieschritt mit dem Aufbringen einer dünnen Schicht aus lichtempfindlichem (bzw. Teilchenstrahl empfindlichem) Material, dem sogenannten Photoresist oder kurz "Resist" auf einen Wafer, insbesondere aus Silizium. Ein Lithographiegerät projiziert dann die auf einer Maske vorhandene Struktur in Gestalt einer oder mehrerer Öffnungen auf den mit dem Resist versehenen Wafer. Zwischen Maske und Wafer befinden sich gegebenenfalls optische Elemente. Die Ausdehnung der projizierten Struktur der Maske auf dem Wafer ist meist sehr viel kleiner als der Wafer. Anschließend an die Projektion wird der Wafer verschoben und dieselbe Struktur der Maske auf eine andere Stelle des Wafers projiziert. Dieser Vorgang des Projizierens und Verschiebens wird solange wiederholt, bis die gesamte Waferfläche genutzt ist. Durch nachfolgendes Entwickeln des Resists wird auf dem Wafer das gewünschte Muster in Form von resistfreien Stellen erhalten. Der Wafer kann dann in weiteren Schritten irgendeinem der bekannten Bearbeitungsvorgänge wie Ätzen, Ionenimplantation oder Aufbringen und Diffusion von Dotierungsmaterial unterzogen werden. Nach diesen weiteren Schritten wird der Wafer kontrolliert, wieder mit Resist überzogen und die gesamte vorerwähnte Schrittfolge etwa 8 - 15 mal wiederholt, bis schließlich eine schachbrettartige Anordnung von identischen Mikroschaltkreisen auf dem Wafer erzeugt ist.

Die meisten heute verwendeten Projektionslithographieverfahren verwenden Licht zur Bestrahlung des Resists, aber das Bedürfnis nach kleineren Strukturen und höherer Dichte der Komponenten der Mikroschaltkreise hat dazu geführt, intensiv nach anderen Bestrahlungsmethoden zu suchen, die in ihrer Auflösung nicht wie bei Anwendung von Licht durch dessen relativ große Wellenlänge beschränkt sind. Große Anstrengungen wurden unternommen, um Röntgenstrahlen in Lithographiegeräten zu verwenden, während andere Verfahren wie z.B. die Teilchen- insbesondere Ionensträhllithographie, zwar einige, aber doch wesentlich weniger Beachtung erfahren haben.

Die Erfindung betrifft nun ein teilchen-, insbes. ionenoptisches Abbildungssystem, bevorzugt für Lithographiezwecke, mit einer Teilchen-, insbes. Ionenquelle zur Abbildung einer auf einer Maske befindlichen Struktur in Gestalt einer oder mehrerer Öffnungen über mindestens zwei zwischen der Maske und einem Wafer befindliche Sammellinsen auf den Wafer. Sammellinsen in Form rotationssymmetrischer elektrostatischer Linsen mit üblichen Elektrodenformen (Rohr, Blende, bzw. Kombinationen solcher Elemente) besitzen ausnahmslos beträchtliche Bildfehler 3. Ordnung, die durch spezielle Gestaltung der Linsengeometrie nur relativ schwach beeinflußbar sind.

Bei Kombination von zwei Sammellinsen, wie sie zum Beispiel in der US-PS 4,985,634 beschrieben wird, lassen sich diese Fehler 3. Ordnung durch geeignete Wahl und Anordnung der beiden Linsen weitgehend kompensieren, doch bleiben Fehler 5. Ordnung, die sich aus dem Produkt der Fehlerkoeffizienten-Matrix ergeben, erhalten.

Hauptziel der Erfindung ist es, ein Abbildungssystem der vorerwähnten Art zu verbessern, um Beschränkungen und Nachteile von bereits existierenden Systemen weitgehend zu vermeiden bzw. zu überwinden. Erreicht wird dies, wenn gemäß der Erfindung mindestens eine der Sammellinsen eine Dreielektroden-Linse ist, welche aus zwei Rohrelektroden besteht, zwischen denen sich eine dritte Elektrode befindet, welche als Platte mit einer Vielzahl von Öffnungen, bevorzugt als Gitter, ausgebildet ist, wobei die Platte, insbes. das Gitter, senkrecht zur optischen Achse angeordnet ist, so daß durch die Platte bzw. das Gitter die Linse in zwei Bereiche geteilt ist, wobei bevorzugt an die drei Elektroden unterschiedliche Spannungen angelegt werden. Die Anwendung von Dreielektroden-Linsen mit Gitter ermöglicht es, jeweils einen Bildfehlerkoeffizienten in den Abbildungsgleichungen zum Verschwinden zu bringen, wobei auch die übrigen Bildfehlerkoeffizienten kleine Werte annehmen im Vergleich zu den bekannten elektrostatischen Linsen. In dem erfindungsgemäßen Abbildungssystem kann somit für jede Sammellinse die Verzeichnung 3. Ordnung sehr stark reduziert werden. Darüberhinaus tritt auch eine Reduzierung der restlichen Verzeichnung an der Stelle des Verzeichnungsminimums auf. Die Anwendung von Dreielektrodenlinsen mit Gitter erlaubt die Verringerung des Abstandes Maske-Wafer gegenüber bekannten Systemen, wenn man die Verzeichnungswerte auf gleiche Bildfeldgröße bezieht. Schließlich wird auch noch die Tiefenschärfe des Abbildungssystems wesentlich erhöht, weil die Dreielektrodenlinsen mit Gitter jeweils nur sehr kleine Bildfehler besitzen und daher die Kompensation der Bildfehler bei den zwischen Wafer und Maske befindlichen Linsen weniger kritisch ist. Mit Anwendung von Dreielektrodenlinsen mit Gitter ist es möglich, teilchen-, insbesondere ionenoptische Abbildungssystemen zu schaffen, bei denen die Teilchenenergie am Masken- und Waferort etwa gleich sind. Damit kann der mit dem Resist beschichtete Wafer mit Teilchen (Ionen) niedriger Energie (z.B. 10KeV) bestrahlt werden, sodaß die Teilchen innerhalb der Resistschicht abgestoppt werden können. Die Erzeugung von Strahlungsschäden in für die Devicefunktion kritischen Schichten und Halbleitermaterialien unter der Resistschicht kann somit vermieden werden. Damit kann eine defektfreie Übertragung von Maskenstrukturen auf ein Wafersubstrat mittels Teilchenstrahlen realisiert werden.

Unter Verwendung von Dreielektroden-Gitterlinsen ist es aber auch möglich, Lithographiesysteme zu realisieren, bei denen die Ionenenergie am Wafer sehr viel höher ist als auf der Maske, zum Beispiel um einen Faktor 25, womit man hohe Ionenenergien (z.B. 100 keV) am Wafer erreichen kann, was zur Erreichung einer genügenden Eindringtiefe der Ionen für viele Anwendungen wichtig ist.

Soferne als Maske eine solche mit nur einer Apertur verwendet wird, können Abbildungssysteme aufgebaut werden, die einen Einzelstrahl relativ niedriger Energie bei hoher Auflösung liefern.

Einer der Linsenbereiche der Dreielektroden-Linse weist positive Brechkraft, der zweite Linsenbereich jedoch negative Brechkraft auf, wobei erfindungsgemäß der absolute Wert der Brechkraft des negative Brechkraft aufweisenden Linsenbereiches (zerstreuender Bereich) geringer ist als die Brechkraft des positive Brechkraft aufweisenden Linsenbereiches (sammelnder Bereich). Bei einem solchen Abbildungssystem kompensieren sich trotz der verschiedenen Absolutbeträge der Brechkräfte die Bildfehlerkoeffizienten, wenn der zerstreuende Bereich entsprechend größere Bildfehler 3. Ordnung besitzt als der sammelnde Bereich. Dies kann etwa in einfacher Weise realisiert werden, wenn in weiterer Ausgestaltung der Erfindung die Rohrelektrode des negative Brechkraft aufweisenden Linsenbereiches geringeren, insbesondere halb so großen, Durchmesser wie die Rohrelektrode des positive Brechkraft aufweisenden Linsenbereiches besitzt und wenn das Spannungsverhältnis zwischen den Elektroden des negative Brechkraft aufweisenden Linsenbereiches ebenfalls geringer, insbesondere halb so groß, wie das Spannungsverhältnis zwischen den Elektroden des positive Brechkraft aufweisenden Linsenbereiches ist.

Die Störungen durch die Öffnungen in der Platte bzw. durch die Gitteröffnungen können vermindert werden, wenn gemäß einer speziellen Ausgestaltung des Erfindungsgegenstandes zu beiden Seiten der Plattenelektrode, bevorzugt der Gitterelektrode, im Bereich der Ausleuchtung durch den Ionenstrahl möglichst gleiche Feldstärken vorhanden sind.

Bei einer weiteren Ausführungsform des erfindungsgemäßen Abbildungssystems ist vorgesehen, daß die Gitterelektrode in der Gitterebene in zwei miteinander einen Winkel von bevorzugt 90° einschließenden Richtungen bewegbar geführt ist. Hiedurch wird der Einfluß der Stege zwischen den Öffnungen in der Platten(Gitter-)elektrode auf die Abbildung (Transmission Maske-Wafer) vermindert. Es kann erreicht werden, daß die Teilchen fronen) von jedem Punkt der Maske auf den Wafer gelangen können, wobei innerhalb der Belichtungszeit jeder Punkt der Platten-(Gitter-)-ebene etwa für den gleichen Bruchteil der Gesamtionenmenge durchlässig ist. Bevorzugt sind die Frequenzen in den beiden Bewegungsrichtungen der Platten-(Gitter-)-elektrode verschieden. Die Amplituden der Bewegung betragen bevorzugt ein Vielfaches, etwa um einen Faktor 5 bis 15, der Weite der Gitteröffnungen. Der Frequenzbereich kann zwischen 100 und 1000 Hz liegen.

Eine andere Möglichkeit, die Transmission Maske-Wafer zu verbessern und mit der Periodizität der Gitterbewegung auftretende Schwankungen zu vermindern, wird in weiterer Ausgestaltung der Erfindung vorgesehen, daß der Durchmesser der virtuellen Quelle ein Vielfaches der Gitteröffnung ist, und insbesondere bei einer Gitteröffnung von 5 ᴠm Weite etwa 60 ᴠm beträgt. Die Vergrößerung der Größe der virtuellen Quelle bringt zwar eine Vergrößerung des Strahlenkegels, der von den Maskenpunkten ausgeht, die jedoch keine merkliche Verschlechterung des Auflösungsvermögens verursacht, da die Dreielektrodenlinsen mit Gitter nur ganz geringe Bildfehler generieren im Vergleich zu herkömmlichen Linsen. Darüberhinaus erlaubt eine größere virtuelle Teilchenquelle die Absaugung einer größeren Teilchenmenge in der Zeiteinheit aus dem Plasmaraum der Quelle und damit eine intensivere Bestrahlung der Maske.

Die Verbesserung der Transmission Maske-Wafer kann in dem erfindungsgemäßen Abbildungssystem auch dadurch erzielt werden, daß der Teilchen-, insbesondere Ionenquelle ein an variable Spannung legbarer Multipol nachgeschaltet ist, der zwischen Quelle und Maske liegt. Der Multipol bewirkt dabei ein Wobbeln der virtuellen Quelle auf elektrostatischem Weg. Dies entspricht einer periodischen Verschiebung der Position der virtuellen Ionenquelle und wirkt in ähnlicher Weise wie eine ausgedehntere Teilchen-(Ionen)-quelle.

Die Erfindung wird nachstehend beispielsweise an Hand der Zeichnung näher erläutert. Es zeigen, die

Fig. 1 und 2 jeweils in einem axialen Längsschnitt Zerstreuungslinsen mit unterschiedlicher Anordnung der Gitterelektrode,

Fig. 3 ebenfalls in axialem Längsschnitt eine drei Elektroden aufweisende Linse, wobei die mittlere Elektrode von einem Gitter gebildet ist,

Fig. 4 ein Diagramm, das die Bildfehlerkoeffizienten 3. Ordnung in Abhängigkeit vom Gesamtspannungsverhältnis für eine Dreielektrodengitterlinse veranschaulicht,

Fig. 5 ein Diagramm analog dem in Fig. 3 gezeigten Diagramm, jedoch für eine Zweielektroden-Feldlinse von bekanntem Aufbau,

Fig. 6 schematisiert in einer Seitenansicht, den Aufbau eines Ionenlithograhpiesystems,

Fig. 7 ein Ionenlithographiesystem der in Fig. 6 dargestellten Art, jedoch mit Verzeichnungskorrektur,

Fig. 8 ebenfalls ein Ionenlithographiesystem der in Fig. 6 dargestellten Art mit Korrektur des chromatischen Fehlers, und

Fig. 9 ein Diagramm zur Veranschaulichung von Verzeichnung und chromatischem Fehler in Abhängigkeit vom Ort des Wafers auf der optischen Achse.

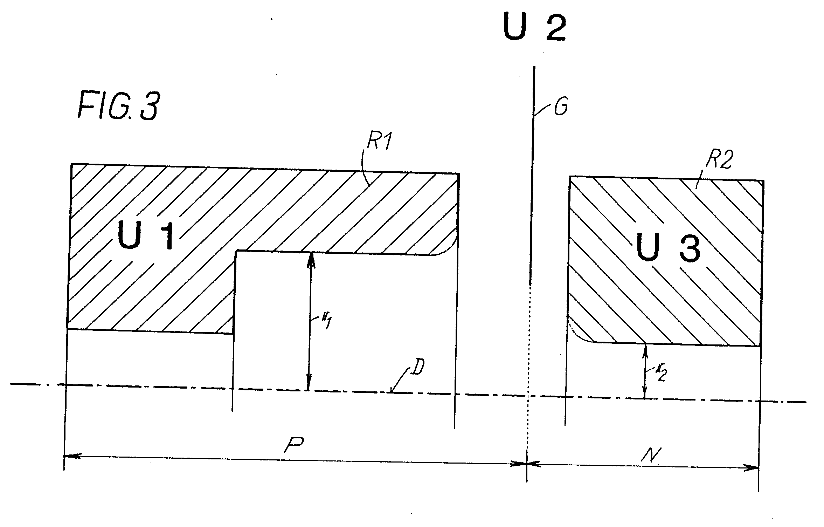

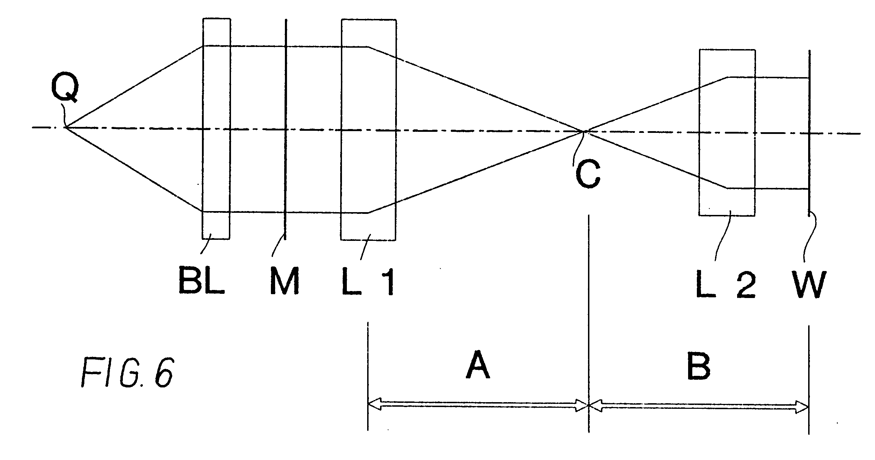

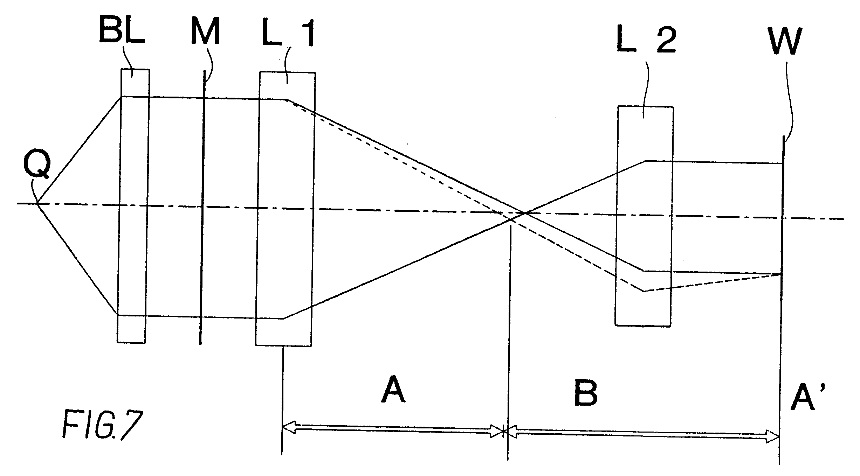

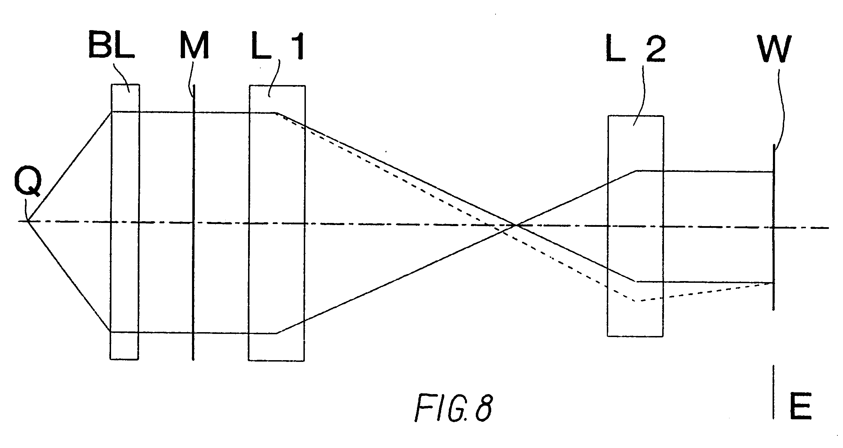

Das ionenoptische Abbildungssystem (Fig. 6) besitzt eine Ionenquelle Q zur Abbildung einer auf einer Maske M befindlichen Struktur auf einen Wafer W. Die Struktur liegt dabei als mindestens eine Öffnung der Maske M vor. Zwischen der Maske M und dem Wafer W befinden sich zwei Sammellinsen L1 und L2. Zwischen der Ionenquelle und der Maske M befindet sich eine Beleuchtungslinse BL zur Erzeugung eines Parallelstrahlenbündels. Mindestens eine Sammellinse ist eine Dreielektrodenlinse. Zwei der Elektroden sind, wie Fig. 3 näher veranschaulicht, als Rohrelektroden R1 und R2 ausgebildet und die zwischen diesen Rohrelektroden R1 und R2 angeordnete, dritte Elektrode wird von einer dünnen Platte gebildet, die eine Vielzahl von Öffnungen aufweist, bevorzugt als Gitter G ausgebildet ist. Das Gitter G ist senkrecht zur optischen Achse D des Abbildungssystems angeordnet und teilt die Linse L1 in zwei Bereiche P und N. An den drei Elektroden, nämlich den beiden Rohrelektroden R1 und R2 und der als Gitter G ausgebildeten Elektrode liegen unterschiedliche Spannungen U1, U2 und U3. Um Beschädigungen des Gitters G zu vermeiden, darf sich in seiner Nähe kein Crossover bilden. Dies wird z. B. für die erste Linse dadurch gewährleistet, daß auf diese ein Parallelstrahlenbündel auftrifft, sodaß sich der Crossover in der bildseitigen Brennebene ergibt.

In dem beschriebenen Beispiel besitzt der Linsenbereich P positive und der Linsenbereich N negative Brechkraft, wobei jedoch der Absolutbetrag der Brechkraft des negative Brechkraft aufweisenden Linsenbereiches N geringer ist als die Brechkraft des positive Brechkraft aufweisenden Linsenbereiches P, so daß die Gesamtbrechkraft der Dreielektrodenlinse L1 positiv ist.

Aus Fig. 3 ist weiters ersichtlich, daß die Rohrelektrode R2 des Linsenbereiches N von negativer Brechkraft geringeren (etwa halb so großen) Durchmesser wie die Rohrelektrode R1 des Linsenbereiches P mit positiver Brechkraft aufweist. Das Spannungsverhältnis (U3 - U0)/(U2 - U0) zwischen den Elektroden des negative Brechkraft aufweisenden Linsenbereiches N ist ebenfalls geringer (etwa halb so groß) wie das Spannungsverhältnis (U3 - U0)/(U1 - U0) zwischen den Elektroden des positive Brechkraft aufweisenden Linsenbereiches P, wobei U0 jenes Potential ist, bei dem die kinetische Energie der verwendeten geladenen Teilchen zu Null wird.

Zu beiden Seiten der Gitterelektrode G bzw. der Plattenelektrode mit Öffnungen wird möglichst gleiche Feldstärke für jenen Bereich angestrebt, der vom Ionenstrahlbündel ausgeleuchtet ist.

Die Platten- bzw. Gitterelektrode G ist in der Gitterebene in zwei zueinander einen Winkel (bevorzugt von 90°) einschließenden Richtungen oszillierend bewegbar.

Zwischen der Quelle Q und der Maske M kann ein (in den Zeichnungen nicht dargestellter) Multipol angeordnet sein, dessen Spannung während des Betriebes, insbesondere kontinuierlich, verändert wird, um einen Effekt zu erreichen, der einer oszillierenden Bewegung der virtuellen Quelle gleichkommt, wodurch verhindert wird, daß die Stege zwischen den Öffnungen der Platte bzw. des Gitters G auf den Wafer W abgebildet werden.

In einer konkreten Ausführung der Dreielektrodenlinse mit Gitter ist der Abstand zwischen den einander zugekehrten Enden der Rohrelektroden R1, R2 90 mm. Die als Gitter G ausgebildete Elektrode ist in einem Abstand von 60 mm von der Austrittsmündung der Rohrelektrode R1 angeordnet, wobei der Durchmesser der Austrittsmündung 200 mm beträgt, wogegen der Durchmesser der Eintrittsmündung der Rohrelektrode R2 100 mm beträgt. Die Austrittsmündung der Rohrelektrode R2 ist von der als Gitter G ausgebildeten Elektrode 450 mm entfernt und die Eintrittsmündung der Rohrelektrode R1 liegt 900 mm vor der als Gitter G ausgebildeten Elektrode. In einem Abstand von 520 mm von der der Gitterelektrode G zugekehrten Austrittsmündung vermindert sich der Innendurchmesser der Rohrelektrode R1 von 200 auf 100 mm.

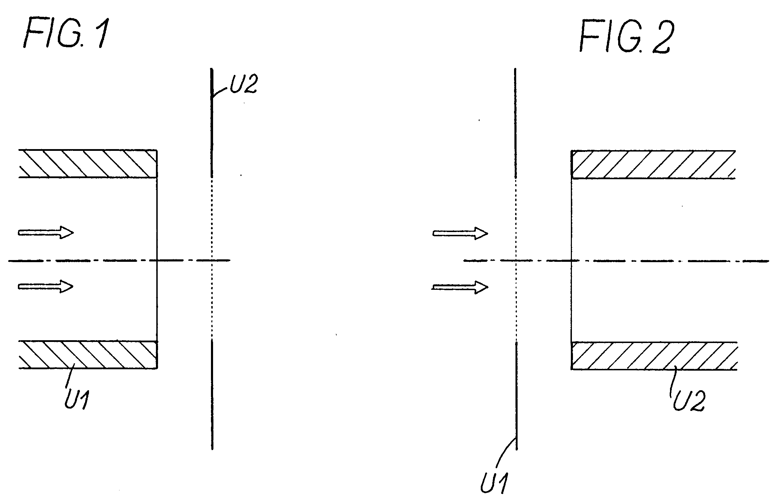

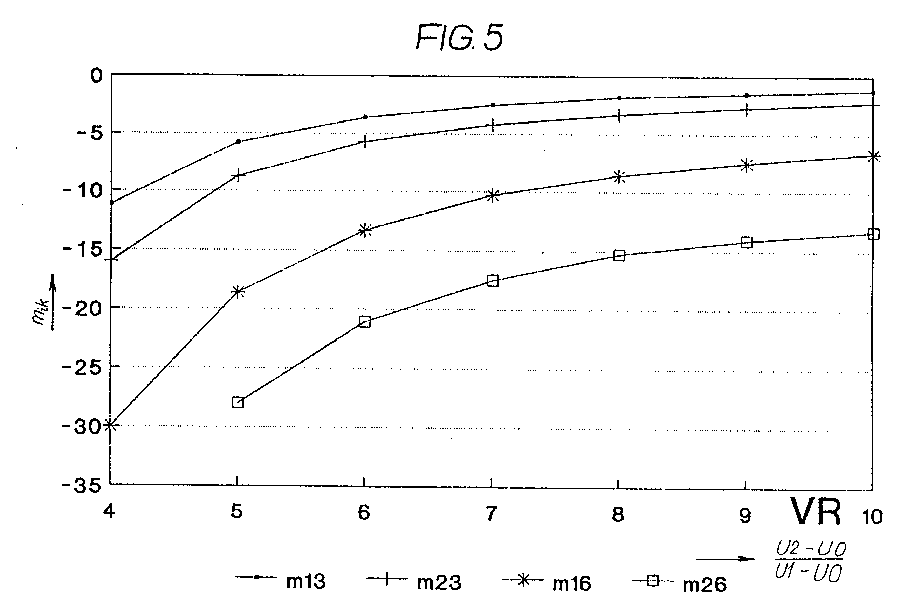

Zur Realisierung sowohl von Sammellinsen als auch von Zerstreuungslinsen ist eine Kombination von Rohr und Platte geeignet, wie dies die Fig. 1 und 2 zeigen.

Zur praktischen Realisierung muß die Platte mit einer Vielzahl von Öffnungen versehen sein, bevorzugt als Gitter ausgebildet werden, um den Teilchendurchgang zu ermöglichen. Weil davon ausgegangen wurde, daß das Gitter den Strahlengang stört, da ein Teil des zur Bilderzeugung verwendbaren Teilchenstrahls von den Gitterstegen absorbiert wird und weiters die einzelnen Gitteröffnungen als "Minilinsen" (flies eyes lenses) wirken, wurden solche Linsen in Anwendungen, die eine hohe Abbildungsqualität erfordern, nicht verwendet.

Die erfindungsgemäß zur Anwendung in teilchenoptischen Abbildungssystemen gelangenden Linsen stellen eine Weiterentwicklung dieser Gitterlinsen dar, die deren prinzipielle Möglichkeiten nutzen und gleichzeitig die negativen Auswirkungen der beschriebenen Störungen durch das Gitter praktisch vermeiden.

Fig. 3 zeigt das Prinzip des Aufbaues einer Drei-Elektroden-Gitterlinse.

Die Linse besteht aus zwei Rohrelektroden R1, R2 mit den Radien $r_1$ und $r_2$ und einer dazwischen angeordneten, als Gitter G ausgebildeten dünnen, ebenen Elektrode, die die Linse in zwei Bereiche P und N teilt.

Die drei Elektroden R1, G und R2 befinden sich auf verschiedenen Potentialen $U_1$, $U_2$ und $U_3$.

Die Potentiale $U_1$, $U_2$, $U_3$ können so gewählt werden, daß die Feldstärken auf beiden Seiten der Gitterelektrode G möglichst exakt gleich sind. Durch diese Maßnahme kann die Störung durch die Gitteröffnungen zum größten Teil eliminiert werden.

Es wird entweder

$$U_1 < U_2 < U_3 < U_0 \text{ oder } U_0 > U_1 > U_2 > U_3$$

gewählt.

Für positiv geladene Teilchen wirkt im ersten Fall ($U_1 < U_2 < U_3 < U_0$) der erste Bereich der Linse zerstreuend (negative Brechkraft) und der zweite Bereich der Linse sammelnd (positive Brechkraft), und im zweiten Fall ($U_0 > U_1 > U_2 > U_3$) wirkt der erste Linsenbereich P als Sammellinse und der zweite Bereich N als Zerstreuungslinse (Fig. 3).

Für negativ geladene Teilchen gelten analoge Verhältnisse: im 1. Fall ($U_0 < U_1 < U_2 < U_3$) positive Brechkraft im ersten Linsenbereich P und negative Brechkraft im 2. Linsenbereich N, im 2. Fall ($U_1 > U_2 > U_3 > U_0$) umgekehrt.

Die resultierende Brechkraft (Brechkraft der gesamten Linse) ergibt sich dann annähernd als Summe der Brechkräfte der beiden Teillinsen (Linsenbereiche P und N).

Ebenso ergeben sich die Bildfehlerkoeffizienten 3. Ordnung als Summen der Bildfehlerkoeffizienten der Linsenbereiche. Da die Bildfehlerkoeffizienten 3. Ordnung für Sammellinsen und Zerstreuungslinsen entgegengesetztes Vorzeichen besitzen, ergibt sich die Möglichkeit, Sammellinsen zu entwerfen, bei denen durch die beschriebene Summenbildung die Bildfehlerkoeffizienten 3. Ordnung sehr klein werden und (bei denen) mindestens einer dieser Koeffizienten exakt zum Verschwinden gebracht werden kann.

Dazu besitzt der zerstreuende Teilbereich der Linse eine geringere Brechkraft als der sammelnde Teilbereich und der zerstreuende Teilbereich ist bezüglich der Bildfehler 3. Ordnung relativ " schlecht", sodaß sich trotz der verschiedenen Absolutbeträge der Brechkräfte die Bildfehlerkoeffizienten kompensieren.

Praktisch realisiert man diese Bedingung, indem man den Durchmesser der Rohrelektrode und das Spannungsverhältnis für den zerstreuenden Teilbereich kleiner (z.B. wie in Fig. 3 ausgeführt halb so groß) wählt als für den sammelnden Teilbereich der Linse.

Zum Nachweis des vorerwähnten Effektes einer Drei-Elektroden-Gitterlinse wurden die Eigenschaften einer Reihe von Linsen der in Fig. 3 wiedergegebenen Bauart numerisch durchgerechnet, d.h. es wurden die Linsenparameter erster, dritter und fünfter Ordnung für verschiedene Werte der Radienverhältnisse $r_1/r_2$ sowie der Abstände der beiden Rohrelektroden R1 und R2 vom Gitter G als Funktion des Spannungsverhältnisses (U3-U0)/(U1-U0) berechnet. Das Potential der Gitterelektrode G ist durch die Bedingung gleicher Feldstärke an beiden Seiten des Gitters G bestimmt.

Diese Rechnungen erfolgten folgendermaßen:

1.) Berechnung der Potentialverteilung bei gegebener Linsengeometrie durch numerische Lösung der Potentialgleichung nach der Methode der finiten Differenzen.

2.) Berechnung der Linsenparameter erster und dritter Ordnung als Funktion des Spannungsverhältnisses (U3-U0)/(U1-U0), wie folgt:

Zunächst wurde aus den aus der Potentialgleichung berechneten Potentialwerten das elektrische Feld bestimmt, wobei sich zeigte, daß zur Erzielung ausreichender Genauigkeit eine zweidimensionale kubische Interpolation notwendig war.

Dann wurde eine Anzahl von Teilchenbahnen durch die Linsen (verteilt über den interessanten Ausleuchtungsbereich der Linsen) mittels numerischer Integration verfolgt. Aus den Positionen der betrachteten Teilchen am Linsenende kann dann die Transfermatrix in erster, dritter und fünfter Ordnung bestimmt werden, wobei auch die Fehler der Matrixelemente bestimmt werden. Berechnungen dieser Art mit verschiedenen Einschußenergien der Ionen [q.(U0-U1), mit q = Ladung des Ions] ergeben dann die Transfermatrix für verschiedene Spannungsverhältnisse.

Als Ergebnis dieser Folge von Rechnungen erhält man aus den asymptotisch projizierten Bahnen die bild- und gegenstandsseitigen Brennweiten f, f', die Lage der Hauptebenen und die Bildfehlerkoeffizienten dritter bzw. fünfter Ordnung für die Transfermatrix von der gegenstandsseitigen zur bildseitigen Brennebene.

Aus diesen Matrixelementen erhält man schließlich die Bildfehlerkoeffizienten $m_{ik}$, definiert durch die Beziehungen (1) und (2) (vgl. E.Harting und F.H.Read, Electrostatic Lenses, Elsevier Scientific Publ. Compl, Amsterdam, 1976, p. 15):

$$r_2 = f\theta_1 + m_{23} f\theta_1{}^3 + m_{24} (f/f') r_1 - \theta_1{}^2 + m_{25} (f/f'^2) r_1{}^2 \theta_1 + m_{26}(f/f'^3)r_1{}^3 \quad (1)$$

$$\theta_2 = - r_1/f' + m_{13}\theta_1{}^3 + m_{14} (1/f') \theta_1{}^2 r_1 + m_{15} (1/f'^2) r_1{}^2 \theta_1 + m_{16} (1/f'^3)r_1{}^3 \quad (2)$$

Dabei sind $r_1$, $\theta_1$ Ort (Abstand von der z-Achse, die mit der optischen Achse zusammenfällt) und Richtung (Winkel mit der positiven z-Achse) eines Ions in der gegenstandsseitigen Brennebene und $r_2$, $\theta_2$ Ort und Richtung des gleichen Ions in der bildseitigen Brennebene der Linse.

Die so definierten Koeffizienten [$m_{ik}$] sind normiert in dem Sinne, daß sie unabhängig sind von einer beliebigen, ähnlichen Vergrößerung oder Verkleinerung der betreffenden Linse. Sie können also unmittelbar zum Vergleich der Qualität verschiedener Linsen verwendet werden.

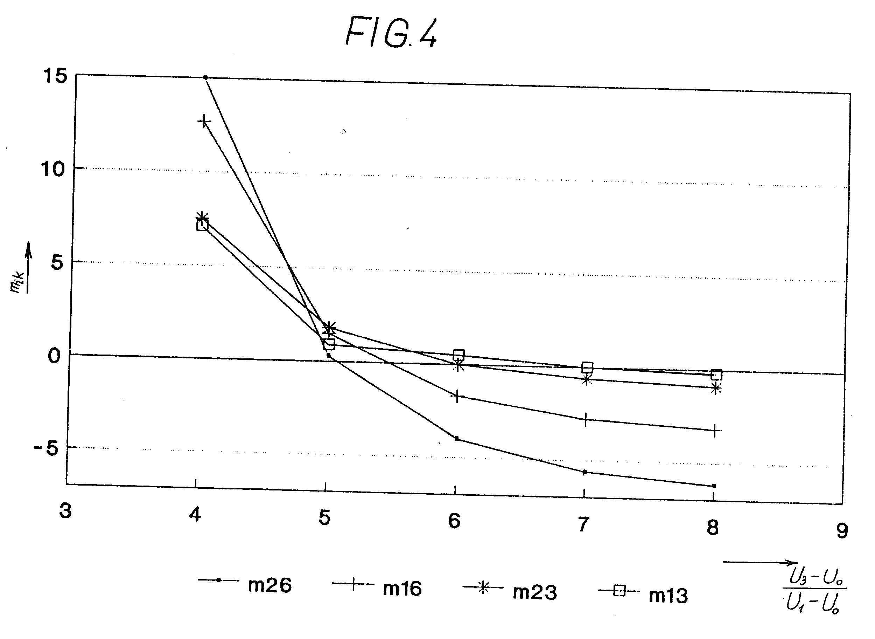

Fig. 4 zeigt einige dieser normierten Bildfehlerkoeffizienten für die in Fig. 3 dargestellte Dreielektroden-Gitterlinse in Abhängigkeit vom Spannungsverhältnis (U3-U0)/(U1 - U0).

Fig. 5 zeigt zwecks Vergleiches diese Koeffizienten für eine in der Ionen/ProjektionsLithographie bisnun verwendete Feldlinse, die als Rohrlinse mit zwei Elektroden ausgebildet war.

Der Vergleich der Abbildungen in Fig. 4 mit jener der Fig. 5 zeigt unmittelbar die Überlegenheit der Drei-Elektroden-Gitterlinse gemäß Fig. 3.

Mit der Drei-Elektroden-Gitterlinse ist es möglich, jeden der Bildfehlerkoeffizienten $m_{13}$, $m_{16}$, $m_{23}$ und $m_{26}$ bei einem bestimmten Spannungsverhältnis (U3 - U0)/(U1 - U0) exakt zum Verschwinden zu bringen, wobei an dieser Stelle des Spannungsverhältnisses auch die übrigen drei dort nicht (exakt) verschwindenden Koeffizienten sehr viel kleinere Werte annehmen als bei der Feldlinse (Rohrlinse).

Die Abschätzung von durch das Gitter selbst hervorgerufenen Abbildungsfehlern, die für die Bestimmung der auszuwählenden Feinheit des Gitters G wichtig ist, läßt sich auf das Problem zurückführen, die fokussierende Wirkung einer kreisförmigen Öffnung mit Radius R, die einen Bereich mit homogenem Feld $E_1$ von einem Bereich mit davon verschiedenem Feld $E_2$ trennt, zu berechnen.

Dieses Problem ist bereits in M.Szilagyi, Electron and Ion Optics, Plenum Press, New York (1988) behandelt. Eine Anordnung dieser Art stellt eine Sammellinse mit der Brennweite

$$f_G = 4 (U - U0)/(E_2 - E_1) \quad (3)$$

dar, wobei U das Potential am Ort der Öffnung ist und $E_2$ und $E_1$ für die Feldstärke vor und hinter dem Gitter G steht.

Damit wird ein Ion, welches die Öffnung durchsetzt, maximal um einen Winkel

$$\simeq \Delta\theta| = R/|f_G| = R|(E_2 - E_1)|/|4(U - U0)| \quad (4)$$

abgelenkt. Diese Ablenkung führt zu einer Verschlechterung der Bildqualität. Um diesen Effekt klein zu halten, müssen sowohl der Durchmesser (2R) der Gitteröffnungen als auch die Feldstärkedifferenzen ($E_2 - E_1$) zwischen Vorder- und Rückseite des Gitters G so klein wie möglich gehalten werden.

Bezüglich der Feinheit des Gitters sind mit modernen Fertigungstechnologien Durchmesser 2 R im Bereich von 5 μm und Gitterstege im Bereich von 1 μm bis 2 μm durchaus möglich.

Bei der Feldstärkedifferenz $E_2$-$E_1$ ist zu beachten, daß es zwar möglich ist, an einem bestimmten Ort des Gitters G durch geeignete Wahl des Gitterpotentials U2 exakt gleiche Feldstärken $E_1$ und $E_2$ zu beiden Seiten des Gitters G zu erzeugen, daß aber wegen der notwendig verschiedenen Radien $r_1$ und $r_2$ der beiden Rohrelektroden R1 und R2 die radiale Abhängigkeit von $E_1$ und $E_2$ verschieden sein muß und daher über die Gitterbereiche, die einer Ausleuchtung der Linse entsprechen, relative Feldstärkenunterschiede von ($E_2$-$E_1$)/$E_1$ von etwa 1 % zugelassen werden müssen.

Setzt man diese Werte in Gleichung (4) ein, so erhält man

$$|\Delta\theta| \qquad 10^{-8}/L(m)$$

mit L.....Ausdehnung der Feldzone der Gitterlinse, annähernd gleich dem Abstand der beiden Rohrelektroden R1, R2 (Fig. 3).

Da der Abstand L im Bereich von einigen Vielfachen von 10 cm liegt, ist es möglich, die Winkelverbiegung gemäß Gleichung (4) auf Werte von (1 bis 10). $10^{-8}$ zu reduzieren, was in den meisten Fällen gegenüber anderen Fehlerquellen (z.B. chromatischen Fehlern) zu vernachlässigen ist. Allerdings setzt dies - wie erwähnt - voraus, daß die Feldstärken $E_1$ und $E_2$ optimal angepaßt sind.

Bei einfachen Gitterlinsen gemäß den Fig. 1 und 2, bei denen nur auf einer Seite ein Feld vorhanden ist, wird die Ablenkung um etwa einen Faktor 100 höher ($|\Delta\theta \simeq 10^{-6}$ bis $10^{-5}$). Damit ist die Verwendung solcher Linsen für anspruchsvolle Anwendungen nicht möglich.

Anhand der Fig. 6 wird der Effekt, der durch die Anwendung zweier, je als Dreielektroden-Gitterlinsen ausgebildeter Sammellinsen L1 und L2 in einem ionenoptischen Abbildungssystem erreichbar ist, näher erläutert.

Die Maske M, welche die abzubildende Struktur in Form von Öffnungen in einer Folie (z.B. aus Silizium) aufweist, wird von einer Ionenquelle Q mit sehr geringer virtueller Quellengröße (annähernd 10 μm) und nachfolgender Beleuchtungslinse BL annähernd parallel beleuchtet und befindet sich annähernd in der Brennebene der ersten auf die Maske M unmittelbar folgenden Sammellinse L1.

Die Sammellinse L1 erzeugt einen Cross-over C (reelles Bild der Ionenquelle Q) kurz hinter dem bildseitigen Brennpunkt. Der gegenstandsseitige Brennpunkt der vor dem Wafer W angeordneten zweiten Sammellinse L2 befindet sich am Ort des Cross-Over C. Damit verlassen die Strahlen die Sammellinse L2 nahezu sämtlich achsparallel und man erhält ein annähernd telezentrisches Abbildungssystem. Dieses hat den Vorteil, daß sich der Abbildungsmaßstab bei kleinen Verschiebungen des Wafers W in Richtung der ionenoptischen Achse nicht ändert.

Dieses System besitzt unabhängig von der Realisierung der beiden Sammellinsen L1 und L2 die folgenden Eigenschaften:

a) Das die Strukturen der Maske auflösende Bildfeld wird durch die Kombination der beiden Sammellinsen L1 - L2 in der Umgebung des bildseitigen Brennpunktes der vor dem Wafer W angeordneten Sammellinse L2 abgebildet, wenn sich die Maske, wie vorgesehen, in der Umgebung des gegenstandsseitigen Brennpunktes der auf die Maske M folgenden Sammellinse L1 befindet.

b) Das Strahlenbündel erhält im allgemeinen durch eine auf die Maske M folgende herkömmliche Sammellinse L1 eine tonnenförmige Verzeichnung Bereich A), die nach dem Cross-over in eine kissenförmige Verzeichnung (Bereich B) übergeht. Im Fall der Verwendung von Drei-Elektroden-Gitterlinsen als Sammellinsen L1 und L2 ist es möglich, daß im Bereich A eine kissenförmige und im Bereich B eine tonnenförmige Verzeichnung vorliegt.

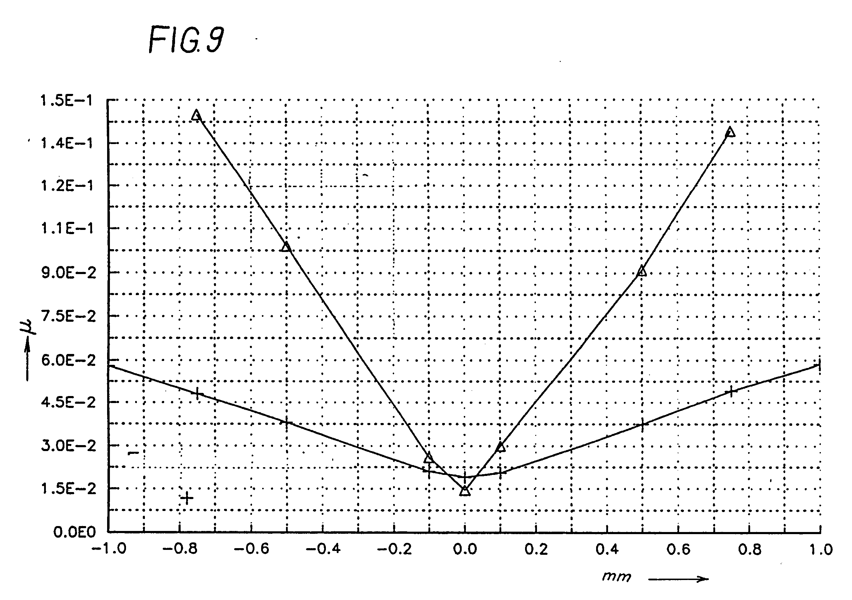

Fig. 7 veranschaulicht für den Fall tonnenförmiger Verzeichnung im Bereich A und kissenförmiger Verzeichnung im Bereich B, daß durch die Verzeichnung der vor dem Wafer W angeordneten Sammellinse L2, die Strahlen eine zusätzliche Ablenkung erhalten, die den Bereich B kissenförmiger Verzeichnung reduziert und einen Bereich A' tonnenförmiger Verzeichnung generiert.

Dabei gibt es hinter der vor dem Wafer W angeordneten Sammellinse L2 eine Ebene, in der sich die durch beide Sammellinsen L1 und L2 hervorgerufenen Verzeichnungen kompensieren. Dies gilt allerdings nur für den Verzeichnungsfehler dritter Ordnung, es bleibt der (sehr viel kleinere) Verzeichnungsfehler fünfter Ordnung, d.h. die Verzeichnung verschwindet nicht zur Gänze, sondern besitzt lediglich ein ausgeprägtes Minimum. Bei vorgegebener Bildfeldgröße ist diese Restverzeichnung umgekehrt proportional zur fünften Potenz des Abstandes Maske M - Wafer W bei gleichzeitiger ähnlicher Änderung aller Dimensionen des optischen Systems zwischen Maske M und Wafer W.

c) In der Anordnung nach Fig. 6 ergibt sich, wie aus Fig. 8 zu erkennen ist, auch für den chromatischen Fehler eine Kompensation durch die Wirkungen der beiden Sammellinsen L1 und L2 für eine bestimmte Bildebene E hinter der vor dem Wafer W angeordneten zweiten Sammellinse L2. Ein Strahl (in Fig. 8 in unterbrochenem Linienzug für den Fall dargestellt, daß die Brechkraftänderung der Sammellinse L1 kleiner ist als jene der Sammellinse L2) mit etwas kleinerer Energie $E_0 - \Delta E_0$ als der Sollenergie $E_0$ wird in der auf die Maske M folgenden ersten Sammellinse L1 stärker abgelenkt, trifft infolgedessen die vor dem Wafer W angeordnete zweite Linse L2 in größerer Achsenferne als der (in vollem Linienzug dargestellte) Sollstrahl und wird daher aus diesem Grund und wegen seiner geringeren Energie um sovielmehr gegen die optische Achse zurückgelenkt, daß er in einer bestimmten Entfernung hinter der vor dem Wafer W angeordneten Sammellinse L2 den Sollstrahl trifft. In dieser Ebene E verschwindet der chromatische Fehler erster Ordnung. Es verbleibt auch hier ein Restfehler, der chromatische Fehler 2. Ordnung, d.h. ein Fehler proportional zum Quadrat der Energieabweichung vom Sollstrahl. (Die Kombination von zwei Drei-Elektroden-Gitterlinsen kann auch so betrieben werden, daß die Brechkraftänderung der Linse L1 größer ist als jene der Linse L2. In diesem Fall gilt Analoges).

d) Die drei relevanten Ebenen, die Gaußsche Bildebene der Maske M (Fig. 6), die Ebene minimaler Verzeichnung (Fig. 7) und die Ebene minimalen chromatischen Fehlers (Fig. 8) werden im allgemeinen nicht zusammenfallen. Durch geeignete Wahl der Sammellinsen L1 und L2 und der Lage der Ionenquelle Q in der ionen-optischen Achse kann jedoch erreicht werden, daß unter Beibehaltung des annähernd parallelen Strahlenganges, die genannten drei Ebenen zusammenfallen. Wird dann der Wafer W dort angeordnet, wo die drei Ebenen zusammenfallen, so bewirkt dies, daß in der so gewählten Bildebene der Maske (d.i. der Ort, in dem der Wafer W angeordnet ist) sowohl ein Minimum der Verzeichnung als auch ein Minimum des chromatischen Fehlers vorhanden ist.

e) Der Abbildungsmaßstab, d.h. der Verkleinerungsfaktor, mit dem die Struktur der Maske M auf den Wafer W abgebildet wird, ist annähernd gegeben durch das Verhältnis der bildseitigen Brennweite der auf die Maske M folgenden ersten Sammellinse L1 zur gegenstandsseitigen Brennweite der vor dem Wafer W angeordneten zweiten Sammellinse L2. Durch Skalierung (ähnliche Vergrößerung oder Verkleinerung von L2) ist es daher möglich, auch den Verkleinerungsfaktor des Abbildungssystems unter Beibehaltung aller übrigen Eigenschaften (gleichzeitige Korrektur von Verzeichnung und chromatischem Fehler am Gaußschen Bildpunkt der Maske) zu verändern.

Die erfindungsgemäße Anwendung der Drei-Elektroden-Gitterlinse bringt, den obigen Ausführungen gemäß, folgende Vorteile:

a) Die Verzeichnung 3. Ordnung kann für jede der beiden Sammellinsen L1 und L2 sehr stark reduziert werden. Da die Strahlen in der gegenstandsseitigen Brennebene von L1 annähernd parallel verlaufen und in der gegenstandsseitigen Brennebene von L2 sich ein Cross-over C befindet, wird für die von dieser Linse erzeugte Verzeichnung jeweils nur ein Koeffizient $m_{26}$ für L1 und $m_{13}$ für L2 maßgebend und diese können - wie erwähnt - durch geeignete Wahl des Spannungsverhältnisses an den Elektroden der Linsen exakt zum Verschwinden gebracht werden. Damit erhält man Verzeichnungsfreiheit in 3. Ordnung nicht mehr nur in einer Ebene (Fig. 7), sondern über einen größeren Bereich, wodurch die Zahl der gleichzeitig zu erfüllenden Bedingungen reduziert wird.

b) Ein noch größerer Vorteil ist die Reduzierung der restlichen Verzeichnung an der Stelle des Verzeichnunsminimums. Dies folgt aus der Tatsache, daß der am Ort des Verzeichnungsminimums maßgebende Koeffizient für die Verzeichnung 5. Ordnung sich zu einem großen Teil aus (dem) Produkt der Verzeichnungskoeffizienten 3. Ordnung der beiden Sammellinsen L1 und L2 zusammensetzt. Bei der Drei-Elektroden-Gitterlinse fallen nun diese Produktterme praktisch weg. Damit bleiben die wesentlich kleineren "echten" Terme 5. Ordnung der beiden Linsen als Ursache einer Restverzeichnung übrig.

Als Ausführungsbeispiele wurden zwei Anordnungen numerisch mit hoher Präzision durchgerechnet: eine Anordnung (A) mit etwa gleicher Ionenenergie an Maske und Wafer und eine zweite Anordnung (B), bei der die Ionen zwischen Maske und Wafer um einen Faktor größer 1 beschleunigt werden.

Entsprechend den zu erwartenden Anforderungen der Halbleiterindustrie wurde dabei die Abbildung einer Maske M, die innerhalb einer Fläche von 60 x 60 mm$^2$ mit Strukturen (z.B. Öffnungen) versehen war, auf eine Chipfläche von 20 x 20 mm$^2$ auf einem Wafer W, anhand einer Anordnung von Linsen gemäß Fig. 6 untersucht.

Als Beleuchtungslinse BL wurde eine EINZEL-Linse, welche einen annähernd parallelen Strahlengang am Ort der Maske M erzeugt, verwendet.

Die erste Sammellinse L1 war eine Drei-Elektroden-Gitterlinse gemäß Fig. 3, an deren Elektroden das Spannungsverhältnis so gewählt wurde, daß der Koeffizient $m_{26}$ verschwindet (Gleichung (1) und Fig. 4).

Die zweite Sammellinse L2 war ebenfalls eine Drei-Elektroden-Gitterlinse gemäß Fig. 3; im Falle A wird sie von rechts nach links durchlaufen und als verzögernde Linse verwendet, sodaß insgesamt die Ionenenergie am Ort der Maske M und des Wafers W etwa gleich sind. Im Fall B wird die zweite Sammellinse L2 genau wie L1 als beschleunigende Linse betrieben, das heißt von links nach rechts durchlaufen. Das Spannungsverhältnis an den Elektroden der Sammellinse L2 wurde in beiden Fällen so gewählt, daß der Koeffizient $m_{13}$ verschwindet.

Die Berechnung der Abbildung der Maskenstruktur auf den Wafer erfolgte nach der Standardmethode der Matrizenmultiplikation. Dabei wurden für die Sammellinsen L1 und L2 die nach der vorstehend angegebenen Methode berechneten Transfermatrizen 5. Ordnung übernommen.

Diese Rechnungen wurden dann innerhalb eines Optimierungsprogrammes unter leichter Variation der Ausgangsparameter wiederholt, bis ein Minimum von Verzeichnung und chromatischer Abberation am Ort der Gaußschen Bildpunkte der (am Wafer abgebildeten) Maske(nstrukturen) erreicht war.

Dabei wurde folgendermaßen vorgegangen:

1. Es wurde verlangt, daß folgende Nebenbedingungen erfüllt sind:

a) Paralleler Strahlengang am Ausgang des Abbildungssystems (d.i. vor dem Wafer, somit nach der dem Wafer vorgelagerten Sammellinse L2).

b) Gaußsche Abbildung der Maske M auf den Wafer W.

c) Abbildungsmaßstab Maske - Wafer: 3 : 1.

2. Folgende Größen wurden, unter Einhaltung der Nebenbedingungen gemäß Punkt 1, zum Zwecke der Bildfehlerminimierung variiert:

a) Abstand zwischen der Maske M und der auf diese folgenden Sammellinse L1,

b) Abstand zwischen den beiden Sammellinsen L1 und L2,

c) Abstand zwischen dem Wafer W und der dem Wafer W vorgelagerten Sammellinse L2,

d) Skalierungsfaktor, d.h. ähnliche Vergrößerung bzw. Verkleinerung der dem Wafer W vorgelagerten Sammellinse L2.

3. Zur weiteren Optimierung wurden auch die Spannungsverhältnisse zwischen den Elektroden der beiden Sammellinsen L1 und L2 variiert. Dabei ergab sich, daß die aufgrund der theoretischen Überlagerungen als Ausgangspunkt gewählten Spannungsverhältnisse (entsprechend $m_{26} = 0$ für L1 und $m_{13} = 0$ für L2) nahezu optimal waren.

4. Zur weiteren Optimierung wurden auch die Spannungsverhältnisse zwischen den beiden Rohrelektroden der beiden Sammellinsen L1 und L2 variiert. Dabei ergab sich, daß die aufgrund der theoretischen Überlegungen als Ausgangspunkt gewählten Spannungsverhältnisse (entsprechend $m_{26} = 0$ für L1 und $m_{13} = 0$ für L2) ebenfalls nahezu optimal waren.

Weiterhin wurde untersucht, welche Auflösungsverschlechterung als Folge der endlichen Größe der Gitteröffnungen auftritt. Dabei wurde ein Durchmesser 2R von 5 μm für die Gitteröffnungen angenommen. Dies geschah folgendermaßen:

1. Aus den Potentialverteilungen der Linsen wurde der maximale Wert der Feldstärkendifferenz $E_2-E_1$ über den ausgeleuchteten Teil der Gitters berechnet.

2. Mit Hilfe von Gleichung (3) wurde daraus die Brennweite der "Gitteröffnungs(Mini)linse" und daraus die maximale Ablenkung der Randstrahlen einer Gitteröffnung berechnet.

3. Mit Hilfe der beschriebenen Matrizenmethode wurden diese Ablenkwinkel in entsprechende Ortsabweichungen am Ort des Wafers W umgerechnet. Diese Berechnung erfolgte getrennt für die Sammellinsen L1 und L2 und am Schluß wurden die Ergebnisse addiert, um eine sichere obere Grenze für den Einfluß der Gitteröffnungen zu erhalten.

Das Ergebnis dieser Berechnungen ist in der nachstehenden Tabelle zusammengestellt.

## TABELLE

|  | Anordnung A | Anordnung B |
|---|---|---|
| Design-Feld der Maske M | $60 \times 60$ mm$^2$ | $60 \times 60$ mm$^2$ |
| Spannungsverhältnis der Sammellinse L1 | 5,90 | 5,57 |
| Skalierung [1]) der Sammellinse L1 | 1,50 | 1,04 |
| Spannungsverhältnis der Sammellinse L2 | 0,1713 | 6,07 |
| Skalierung [1]) der Sammellinse L2 | 0,50 | 0,93 |
| Abstand Maske M - Wafer W | 3,15 m | 3,00 m |
| Verkleinerungsfaktor | 3,0 | 3,0 |
| (Ionenenergie)$_{Wafer}$/(Ionenenergie)$_{Maske}$ | 1,01 | 33,8 |
| maximale Verzeichnung [2]) (innerhalb des $20 \times 20$ mm$^2$ Belichtungsfeldes des Wafers W) | 0,015 $\mu$m | 0,030 $\mu$m |
| maximale chromatische Verbreiterung (aufgrund der Energieverschmierung [3])) | 0,019 $\mu$m | 0,035 $\mu$m |
| maximale Verbreiterung aufgrund der Linsenwirkung der Gitteröffnungen[4]) | 0,020 $\mu$m | 0,037 $\mu$m |

[1]) Ähnliche Vergrößerung bzw. Verkleinerung relativ zu Fig. 3.

[2]) Maximale Abweichung irgendeines Bildpunktes von der idealen Abbildung.

[3]) Für Energieverschmierung der Ionen am Ionenquellenausgang von $\Delta E = ^+ 3$ Ev, wobei E die Energie der Ionen am Ausgang der Ionenquelle ist.

[4]) Für Gitteröffnungen von 5 $\mu$m Durchmesser.

Es zeigt sich, daß die Struktur eines Feldes von 60 mm x 60 mm auf die Maske sich mit Verkleinerung 3 auf den Wafer abbilden läßt, und an dem Bildort gleichzeitig ein Minimum der Verzeichnung und der Bildunschärfe infolge des chromatischen Fehlers (Unschärfe der Ionenenergie) erreicht wird. Die maximale Verzeichnung am Ort des Bildes infolge Bildfehler 5. Ordnung bleibt im gesamten Bildfeld < 0,015 $\mu$m (Fall A) bzw. < 0,03 $\mu$m (Fall B), die Bildunschärfe < 0,04 $\mu$m (Fall A) bzw. < 0,07 $\mu$m (Fall B) bei einer angenommenen Maschinenlänge (Abstand Maske - Wafer) von ca. drei Metern.

Vergleicht man dies mit den Angaben in der US-PS 4 985 634, so erkennt man unmittelbar die bei Verwendung von Drei-Elektroden-Gitterlinsen als Sammellinsen zwischen Maske und Wafer erzielbare Verbesserung.

Für die in der vorerwähnten US-PS beschriebene Maschine wird bei einer Maschinenlänge (Abstand Maske - Wafer) von 2,1 m und einem Bildfeld von 10 mm x 10 mm eine maximale Verzeichnung kleiner 0,2 $\mu$m erreicht. Zum Vergleich der beiden Anordnungen müssen die Verzeichnungswerte auf gleiche Bildfeldgrößen bezogen werden. Durch Ähnlichkeitstransformation ergibt sich, daß in einem Ionenprojektionslithographiesystem nach dem genannten US-Patent für ein Bildfeld von 20 mm x 20 mm, wenn dort eine Verzeichnung von maximal 0,4 $\mu$m erreicht werden soll, eine Maschinenlänge von 4,2 m erforderlich wäre (ähnliche Vergrößerung des Gesamtsystems Faktor 2). Durch die vorgeschlagene Verwendung von Drei-Elektroden-Gitterlinsen kann die Länge des Ionenprojektionslithographiesystems um ca. 15 % (gegenüber 4,2 m) reduziert und gleichzeitig die Verzeichnung um einen Faktor 10 bis 20 verringert werden. Dieser Unterschied kann in vielen Fällen maßgebend für die Entscheidung für die Anwendung eines Ionenprojektionslithographiesystems mit Drei-Elektroden-Gitterlinsen sein.

Ferner wird durch die Verwendung von Drei-Elektroden-Gitterlinsen gemäß dem erfindungsgemäßen Abbildungssystem die Tiefenschärfe wesentlich vergrößert, da wegen der sehr kleinen Bildfehler der Sammellinsen L1, L2 die Kompensation der Bildfehler weniger kritisch ist.

Bei Verwendung von Drei-Elektroden-Gitterlinsen in einem erfindungsgemäßen Ionenstrahllithographiesystem ist bei Beleuchtung der Maske M durch eine Ionenquelle Q mit sehr geringer virtueller Quellgröße (annähernd 10 µm) noch auf folgendes zu achten:

Mit den bisher verwendeten Ionenquellen geringer virtueller Quellgröße würde eine sehr inhomogene Intensität innerhalb des Belichtungsfeldes eintreten. In diesem Fall würde der von einem Maskenpunkt ausgehende Strahlenkegel an dem Ort des Gitters von etwa gleicher Größe wie eine Gitteröffnung sein. Die Transmission Maske - Wafer würde daher mit der Periodizität des Gitters sehr stark schwanken.

Dies läßt sich jedoch durch Bewegung des Gitters (Wobbeln), durch Verwendung von ausgedehnteren Ionenquellen sowie durch periodisches elektrostatisches Verschieben (Wobbeln) der virtuellen Quelle beseitigen.

Damit die Ionen beim Wobbeln des Gitters von jedem Punkt der Struktur der Maske zum Wafer gelangen können, muß das Gitter G so bewegt werden, daß innerhalb der Belichtungszeit jeder Punkt der Gitterebene etwa für den gleichen Bruchteil der Gesamtionenmenge durchlässig ist. Dies kann erreicht werden, wenn das Gitter in zwei zueinander senkrechte Richtungen in der Gitterebene mit zwei verschiedenen Frequenzen und mit einer Amplitude entsprechend einigen Gitteröffnungsdurchmessern, periodisch bewegt wird. Dies bedeutet Schwingungsamplituden von einigen 10 µm und Frequenzen in einem Bereich von 10 bis 10 Hz, was z. B. durch Piezoantrieb ohne größere Schwierigkeiten realisierbar ist.

In den bisherigen Ionenlithographiesystemen war es notwendig, Ionenquellen mit sehr kleiner virtueller Quellgröße zu verwenden, um den Öffnungswinkel der von den Maskenpunkten ausgehenden Strahlenkegel so klein zu halten, daß die Linsenfehler der Sammellinsen L1 und L2 noch zu keiner merklichen Auflösungsverschlechterung führte. Diese Bedingung führte zu dem schon oben genannten Quelldurchmesser von annähernd 10 µm.

Bei Verwendung von Drei-Elektroden-Gitterlinsen sind die Bildfehler nun aber soviel kleiner, daß wesentlich größere Öffnungswinkel und damit Ionenquellgrößen möglich werden.

Numerische Rechnungen haben gezeigt, daß bei der Anordnung gemäß vorstehender Tabelle, eine virtuelle Quellgröße von 60 µm im Durchmesser nur zu einem zusätzlichen Beitrag in der Auflösung von 7 nm (Fall A) bzw. 14 nm (Fall B) führt. Dieser Einfluß ist also klein gegenüber den anderen Beiträgen zur Auflösung.

Bei dieser doch relativ großen virtuellen Quelle wird - wie ebenfalls durch Rechnungen bestätigt - die Ausdehnung der von einem Maskenpunkt ausgehenden Strahlenbündel auf jedem der beiden Gitter der Linsen L1 und L2 ca. 30 µm, d.h. der Bereich deckt etwa 20 Gitteröffnungen, wodurch eine praktisch gleichmäßige Transmission von der Maske zum Wafer sichergestellt wird.

Diese Möglichkeit wird als technisch einfacher im allgemeinen vorzuziehen sein. Sie hat zusätzlich den Vorteil, daß die Raumladung am Ort des Cross-overs C (Fig. 6) wesentlich kleiner bleibt und so unerwünschte Raumladungseffekte mit Sicherheit vermieden werde können. Weiters kann aus einer 60 µm großen Quelle Q mehr Strom entnommen werden.

Eine ausgedehntere Ionenquelle kann auch durch elektrostatisches Wobbeln des die Maske beleuchtenden Ionenstrahls erreicht werden. Dies entspricht ionen-optisch der periodischen Verschiebung der virtuellen Ionenquelle quer zur ionenoptischen Achse. Technisch kann dies dadurch bewerkstelligt werden, daß an geeigneter Stelle zwischen Ionenquelle und Beleuchtungslinse BL ein elektrostatischer Multipol angeordnet wird, in dem zeitlich variierte Dipolfelder in X und Y Richtung erzeugt werden. Damit wird die Einfallsrichtung des Ionenstrahls auf die Maske zeitlich variiert, was einer Verschiebung der virtuellen Quelle in X und Y Richtung und damit einer effektiv ausgedehnteren Ionenquelle entspricht.

## Patentansprüche

1.  Teilchen-, insbes. ionenoptisches Abbildungssystem, bevorzugt für Lithographiezwecke, mit einer Teilchen-, insbes. Ionenquelle zur Abbildung einer auf einer Maske befindlichen Struktur in Gestalt einer oder mehrerer Öffnungen über mindestens zwei zwischen der Maske und einem Wafer befindliche Sammellinsen auf den Wafer, dadurch gekennzeichnet, daß mindestens eine der Sammellinsen (L1, L2) eine Dreielektroden-Linse ist, welche aus zwei Rohrelektroden (R1, R2) besteht, zwischen denen sich eine dritte Elektrode befindet, welche als Platte mit einer Vielzahl von Öffnungen, bevorzugt als Gitter (G), ausgebildet ist, wobei die Platte, insbes. das Gitter (G), normal zur optischen Achse (D) angeordnet ist, so daß durch die Platte bzw. das Gitter (G) die Linse (L1 bzw. L2) in zwei Bereiche (P, N) geteilt ist, wobei bevorzugt an die drei Elektroden (R1, R2, G) unterschiedliche Spannungen (U1, U2, U3) angelegt werden.

2.  Abbildungssystem nach Anspruch 1, dadurch gekennzeichnet, daß einer der Linsenbereiche (P) positive Brechkraft, der zweite Linsenbereich (N) jedoch negative Brechkraft aufweist und daß der absolute Wert der Brechkraft des negative Brechkraft aufweisenden Linsenbereiches (zerstreuender Bereich) (N) geringer ist als die Brechkraft des positive Brechkraft aufweisenden Linsenbereiches (sammelnder Bereich) (P).

3. Abbildungssystem nach Anspruch 2, dadurch gekennzeichnet, daß die Rohrelektrode (R2) des negative Brechkraft aufweisenden Linsenbereiches (N) geringeren, insbesondere halb so großen, Durchmesser wie die Rohrelektrode (R1) des positive Brechkraft aufweisenden Linsenbereiches (P) besitzt und daß das Spannungsverhältnis zwischen den Elektroden des negative Brechkraft aufweisenden Linsenbereiches (N) ebenfalls geringer, insbesondere halb so groß, wie das Spannungsverhältnis zwischen den Elektroden des positive Brechkraft aufweisenden Linsenbereiches (P) ist.

4. Abbildungssystem nach einem der Ansprüche 1 bis 3, dadurch gekennzeichnet, daß zu beiden Seiten der Plattenelektrode, bevorzugt der Gitterelektrode (G), im Bereich der Ausleuchtung durch den Ionenstrahl möglichst gleiche Feldstärken vorhanden sind.

5. Abbildungssystem nach einem der Ansprüche 1 bis 4, dadurch gekennzeichnet, daß die Weite der Öffnungen der Gitterelektrode (G) wesentlich größer, z.B. im Verhältnis 3 : 1 bis 5 : 1, als die Weite der zwischen den Öffnungen befindlichen Stege ist.

6. Abbildungssystem nach Anspruch 5, dadurch gekennzeichnet, daß die Weite der Öffnungen der Gitterelektrode (G) ungefähr 5 μm und die Breite der Gitterstege bevorzugt etwa 1 - 2 um beträgt.

7. Abbildungssystem nach einem der Ansprüche 1 bis 5, dadurch gekennzeichnet, daß die Gitterelektrode (G) in der Gitterebene in zwei miteinander einen Winkel von bevorzugt 90° einschließenden Richtungen bewegbar geführt ist.

8. Abbildungssystem nach einem der Ansprüche 1 bis 6, dadurch gekennzeichnet, daß der Durchmesser der virtuellen Quelle bedeutend größer als die Gitteröffnung ist, und insbesondere bei einer Gitteröffnung von 5 μm Weite etwa 60 μm beträgt.

9. Abbildungssystem nach einem der Ansprüche 1 bis 6, dadurch gekennzeichnet, daß der Teilchen-, insbesondere Ionenquelle (Q) ein an variable Spannung legbarer Multipol nachgeschaltet ist, der bevorzugt zwischen Quelle (Q) und Maske (M) liegt.

FIG.1

FIG.2

U2

U1

U2

U1

FIG.5

FIG.3

U 2

G

R1

R2

U 1

U 3

$h_1$

$h_2$

D

P

N

FIG.4

EP 0 564 438 A1

FIG.6

FIG.7

FIG.8

EP 0 564 438 A1

FIG.9

EP 0 564 438 A1

**Europäisches Patentamt**

# EUROPÄISCHER RECHERCHENBERICHT

Nummer der Anmeldung

EP    93 89 0058

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,A | EP-A-0 344 646 (IMS IONEN MIKROFABRIKATIONS SYSTEME) <br> * Zusammenfassung * <br> * Seite 8, Zeile 14 - Seite 9, Spalte 1; Abbildung 2 * <br> --- | 1,9 | H01J37/12 <br> H01J37/30 |
| A | JOURNAL OF VACUUM SCIENCE AND TECHNOLOGY: PART A <br> Bd. 4, 1986, NEW YORK US <br> Seiten 226 - 229 <br> KENICHI SAITO ET AL. 'DESIGN METHOD FOR AN ELECTROSTATIC EINZEL LENS HAVING AN ASYMMETRIC STRUCTURE' <br> * Seite 226, linke Spalte, Absatz 1 - Seite 227, linke Spalte, letzter Absatz; Abbildung 1 * <br> --- | 1 | |
| P,A | EP-A-0 523 033 (IMS IONEN MIKROFABRIKATIONS SYSTEME) <br> * Anspruch 1 * <br> * Spalte 6, Zeile 44 - Zeile 50 * <br> * Spalte 7, Zeile 49 - Spalte 8, Zeile 10; Abbildungen 2,6 * <br> --- | 1,2 | |
| P,A | REVIEW OF SCIENTIFIC INSTRUMENTS <br> Bd. 63, Juni 1992, NEW YORK US <br> Seiten 3339 - 3345 <br> D. OLSON ET AL. 'CHROMATIC ABERRATION OF THREE-CYLINDER ELECTROSTATIC LENSES' <br> * Seite 3339, linke Spalte, Absatz 1 -Absatz 2; Abbildung 1 * <br> ----- | 1 | |

**RECHERCHIERTE SACHGEBIETE (Int. Cl.5)**

H01J

Der vorliegende Recherchenbericht wurde für alle Patentansprüche erstellt

| Recherchenort | Abschlußdatum der Recherche | Prüfer |
|---|---|---|
| DEN HAAG | 16 JULI 1993 | GREISER N. |

EPO FORM 1503 03.82 (P0403)